# DEMANDE DE BREVET EUROPEEN

(11) **EP 2 685 500 A1**
(43) Date de publication de la demande: **15.01.2014**
(21) Numéro de dépôt: 13175435.0
(22) Date de dépôt: 05.07.2013
(51) Int. Cl.: H01L 27/12, H01L 27/02, H01L 27/06

(54) **Circuit integré sur soi comprenant un thyristor (scr) de protection contre des décharges électrostatiques**

(30) Priorité: 13.07.2012 FR 1256802
(71) Demandeur: Commissariat à l'Énergie Atomique et aux Énergies Alternatives, 75015 Paris (FR); STmicroelectronics SA, 92120 Montrouge (FR)
(72) Inventeur: Fenouillet-Beranger, Claire, 38000 GRENOBLE (FR); Fonteneau, Pascal, 38570 THEYS (FR)
(74) Mandataire: Guérin, Jean-Philippe

(57) **Abrégé**

L'invention concerne un circuit intégré (9), comprenant :
-des premier et deuxième composants électroniques (1, 2);
-une couche isolante enterrée (92) de type UTBOX ;
-des premier et deuxième plans de masse (11, 21) à l'aplomb des premier et deuxième composants électroniques ;
-des premier et deuxième caissons (12, 22) en contact;
-des première et deuxième électrodes (14, 24) de polarisation en contact avec les premier et deuxième caissons et avec les premier et deuxième plans de masse;
-une troisième électrode (17) en contact avec le premier caisson;
-une première tranchée d'isolation (62) séparant les première et troisième électrodes et s'étendant au travers de la couche isolante enterrée (92) jusque dans le premier caisson ;
-une deuxième tranchée d'isolation (13) isolant la première électrode du premier composant, et ne s'étendant pas jusqu'à l'interface entre le premier plan de masse et le premier caisson.

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (« latchup » en langue anglaise) rencontré par les transistors MOS en technologie Bulk peut être évité. De tels circuits s'avèrent donc particulièrement adaptés pour des applications de type SoC ou MEMS. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on rabaisse la tension de seuil de certains transistors des portes logiques à accès rapide, et on augmente la tension seuil d'autres transistors des portes logiques à faible consommation. En technologie Bulk, la modulation du niveau de tension de seuil de transistors de même type est effectuée en différenciant le niveau de dopage de leur canal. Cependant, en technologie FDSOI (pour « Fully Depleted Silicium On Insulator » en langue anglaise, désignant du silicium totalement déserté sur isolant), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études pour réaliser des transistors de même type à tensions de seuil distinctes est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser un plan de masse polarisé disposé entre une couche d'oxyde isolante mince et le substrat de silicium. En jouant sur le dopage des plans de masse et sur leur polarisation, on peut définir une gamme de tensions de seuil pour les différents transistors. On pourra ainsi disposer de transistors à faible tension de seuil dits LVT (typiquement 400mV), de transistors à haute tension de seuil dits HVT (typiquement 550mV) et de transistors à tension de seuil moyenne dits SVT (typiquement 450mV).Pour permettre le fonctionnement des différents transistors, il est nécessaire de les isoler électriquement les uns des autres. Par conséquent, les transistors sont généralement entourés par des tranchées d'isolation (désignées par l'acronyme STI pour « Shallow Trench Isolation » en langue anglaise) qui s'étendent jusqu'aux caissons.

De façon connue, de tels circuits intégrés incluent également des dispositifs de protection contre des décharges électrostatiques (ESD, pour « Electrostatic Discharge » en langue anglaise) accidentelles et pouvant détériorer ces transistors.

Le document « Multi-VT UTBB FDSOI Device Architectures for Low-Power CMOS Circuit », publié par IEEE Transactions on Electron Devices, IEEE Service Center aux pages 2473-2482, dans le volume 58, n °8 du 1er Août 2011, décrit un circuit intégré muni de premier et deuxième transistors FDSOI disposés sur une couche isolante enterrée de type UTBOX. Des premier et deuxième plans de masse sont disposés à l'aplomb des premier et deuxième transistors respectivement, sous la couche isolante enterrée. Des premier et deuxième caissons présentent des types de dopage opposés et sont disposés respectivement sous les premier et deuxième plans de masse, à l'aplomb de ceux-ci. Les premier et deuxième caissons sont polarisés par des tensions de polarisations différentes.

Il existe un besoin pour des dispositifs de protection contre les décharges électrostatiques n'affectant que marginalement la densité d'intégration, permettant d'assurer une protection locale du circuit intégré, et assurant si possible une protection quelle que soit la polarité de la décharge. L'invention porte ainsi sur un circuit intégré tel que détaillé dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue de dessus schématique d'une portion de circuit intégré selon un premier mode de réalisation de l'invention ;
- la figure 2 illustre une vue en coupe transversale du circuit intégré de la figure 1 ;
- la figure 3 est un schéma électrique correspondant à un circuit de protection du circuit intégré ;
- la figure 4 est un schéma électrique d'un exemple d'application du circuit intégré de la figure 1 ;
- la figure 5 illustre une vue en coupe transversale d'un circuit intégré selon un deuxième mode de réalisation ;
- la figure 6 est un schéma électrique d'un exemple d'application du circuit intégré de la figure 5 ;
- la figure 7 est un schéma électrique d'un autre exemple d'application du circuit intégré de la figure 1 ;
- la figure 8 illustre une vue en coupe transversale d'une variante du circuit intégré de la figure 1.

L'invention propose d'utiliser, dans un circuit intégré, des tranchées d'isolation de profondeur et de dimensions réduites afin de réaliser des dispositifs de protection ESD du circuit intégré. De tels dispositifs de protection, ménagés sous les composants électroniques, ne nuisent pas à la densité d'intégration du circuit et permettent d'assurer une protection localisée de ces composants.

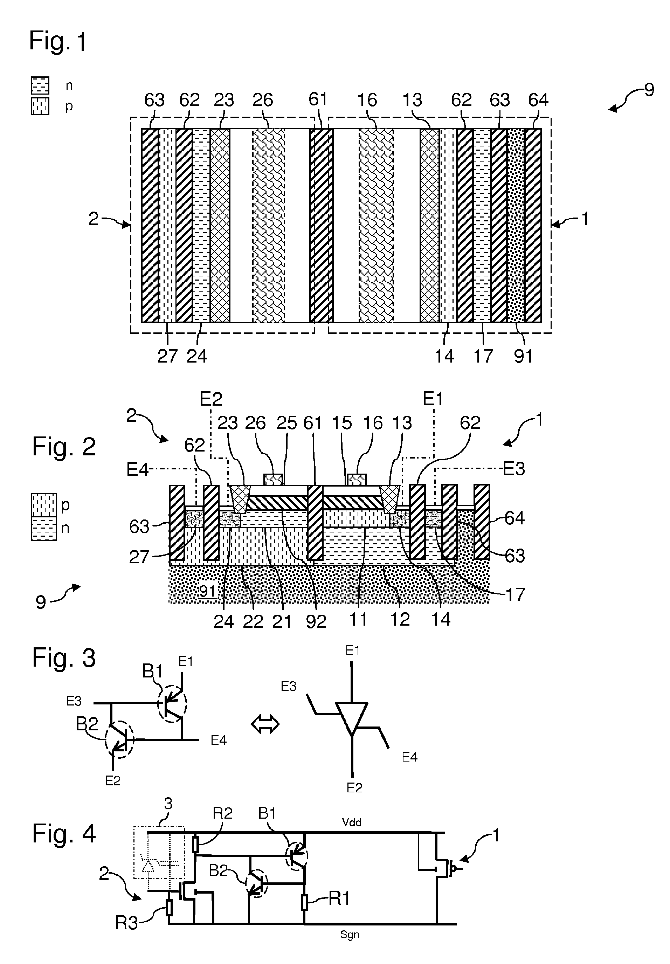

La figure 1 est une vue de dessus schématique d'une portion d'un circuit intégré 9 fabriqué sur SOI, en coupe au niveau de plans de masse et d'implants (ou zones implantées). Les termes 'implant' et 'zone implantée' seront équivalents dans la suite de la description. Le circuit intégré 9 comporte ici une cellule comprenant des composants électroniques 1 et 2. La figure 2 est une vue en coupe transversale de la cellule. Les composants électroniques 1 et 2 sont réalisés dans une couche d'un matériau semi-conducteur, dite couche active, formée sur une couche isolante 92, cette couche isolante 92 étant formée à l'aplomb d'un substrat semi-conducteur 91 à dopage de type p.

Les composants électroniques 1 et 2 sont en l'occurrence des transistors à effet de champ de type FDSOI. Les composants 1 et 2 peuvent également être des FED (pour « Field Effect Diode » en langue anglaise), des FER (pour « Field Effect Resistance » en langue anglaise), des capacités ou des Z²-FET.

Les transistors 1 et 2 sont par exemple respectivement des transistors pMOS et nMOS. Les transistors sont généralement alignés dans une rangée de cellules incluant chacune un transistor nMOS et un transistor pMOS. Les transistors nMOS des différentes cellules sont alors alignés.

Les transistors 1 et 2 comportent une source, un drain et un canal, et un empilement de grille réalisé à l'aplomb du canal. La source, le drain et le canal des transistors 1 et 2 sont ménagés respectivement dans des couches actives semi-conductrices 15 et 25. Les transistors 1 et 2 comportent des empilements de grille respectifs 16 et 26 disposés respectivement sur les couches actives semi-conductrices 15 et 25, à l'aplomb du canal. Pour simplifier les dessins, la structure détaillée des couches actives n'y est pas représentée. Les transistors de la couche active peuvent comporter un canal en matériau semi-conducteur faiblement dopé, avec une concentration de dopants sensiblement égale à la concentration de dopants du substrat 91. Les transistors 1 et 2 comportent également des électrodes de source et de drain respectives, non illustrées.

Des plans de masse 11 et 21 semi-conducteurs sont formés respectivement à l'aplomb des transistors 1 et 2, sous la couche isolante enterrée 92. Le dopage du plan de masse 11 est de type p, celui du plan de masse 21 est de type n.

Les plans de masse 11 et 21 sont polarisés respectivement par des implants 14 et 24 semi-conducteurs. Les implants 14 et 24 présentent des dopages respectifs de type p et n (et de préférence des dopages P+, N+ respectivement). La polarisation des plans de masse 11 et 21 peut être effectuée par l'intermédiaire d'un circuit de polarisation non représenté ici. Les implants 14 et 24 sont coplanaires aux plans de masse 11 et 21. Par coplanaire, on entend que l'on peut définir un plan parallèle à la couche 92 et traversant les zones concernées.

Des caissons 12 et 22 semi-conducteurs sont formés respectivement, à l'aplomb des plans de masse 11 et 21. Les dopages des caissons 12 et 22 sont respectivement de type n et de type p. Les implants 14 et 24 sont en contact respectivement avec les caissons 12 et 22. Les implants 14 et 24 permettent ainsi à la fois de polariser les plans de masse 11 et 21, et de former des entrées pour un dispositif de protection contre les décharges électrostatiques entre deux potentiels.

Les caissons 12 et 22 sont polarisés respectivement par des implants 17 et 27 semi-conducteurs. Les implants 17 et 27 présentent des dopages respectifs de type n et p (et de préférence des dopages N+, P+ respectivement). La polarisation des caissons 12 et 22 peut être effectuée par l'intermédiaire d'un circuit de polarisation non représenté ici. Le transistor 1 est ici disposé entre le transistor 2 et les implants 14 et 17. De façon similaire, le transistor 2 est ici disposé entre le transistor 1 et les implants 24 et 27.

Un caisson profondément enterré de type n peut être ménagé pour former une séparation entre les caissons 12, 22 et le substrat 91 à dopage de type p.

La couche isolante enterrée 92, de façon connue en soi, isole électriquement les transistors 1 et 2 de leur plan de masse, de leur caisson, et du substrat 91.

La couche isolante enterrée 92 formée à l'aplomb des transistors est ici de type UTBOX (« Ultra-Thin Buried Oxide Layer » en langue anglaise). Ainsi, le contrôle de la polarisation des plans de masse 11 et 21 (aussi appelés grilles arrière, ou 'back gates' en langue anglaise) permet de moduler les tensions de seuil respectives des transistors 1 et 2. La couche isolante 92 présente par exemple une épaisseur inférieure ou égale à 60nm, inférieure ou égale à 50nm, voir inférieure ou égale à 20nm. La couche isolante 92 peut être réalisée de façon connue en soi en oxyde de silicium.

Un contact de polarisation du substrat 91 est ici illustré, pour polariser le substrat 91 par exemple à une tension de masse Gnd.

Des tranchées d'isolation profondes 61 et 63 sont ménagées à la périphérie de chacun des transistors 1 et 2. Les tranchées d'isolation 61 et 63 s'étendent en profondeur au travers de la couche isolante 92, jusque dans les caissons respectifs 12 et 22 pour les transistors 1 et 2. Une tranchée d'isolation profonde 64 est ici ménagée pour isoler le contact de polarisation du substrat 91.

Les transistors 1 et 2 comportent en outre des tranchées d'isolation profondes 62. Les tranchées d'isolation 62 s'étendent en profondeur au travers de la couche isolante 92, jusque dans les caissons respectifs 12 et 22 pour les transistors 1 et 2, sans atteindre le substrat 91. Les caissons 12 et 22 s'étendent latéralement à l'aplomb des implants 14,17 et 24, 27 respectivement, et sous les tranchées d'isolation 62. Les tranchées d'isolation 62 assurent une isolation entre les implants 14,17 et 24, 27 respectivement. Les tranchées d'isolation profondes 61 à 64 présentent ici avantageusement une profondeur identique.

Des tranchées d'isolation 13 et 23 sont ménagées à l'aplomb du contact entre les plans de masse 11, 21 et les implants 14, 24 respectivement. Les tranchées d'isolation 13 et 23 sont moins profondes que les tranchées d'isolation 61 à 64.

Les tranchées d'isolation 13 et 23 ne s'étendent pas jusqu'à leurs caissons 12 et 22 respectifs. Les tranchées d'isolation 13 et 23 traversent ici la couche isolante 92 et s'étendent donc jusque dans leurs plans de masse 11 et 21 respectifs. Les tranchées d'isolation 13 et 23 permettent d'améliorer l'isolation entre les transistors 1 et 2 et leurs implants 14 et 24 tout en rendant possible la polarisation des régions 11 et 21.

Les caissons 12 et 22 peuvent présenter des concentrations de dopants comprises entre 10¹⁶cm⁻³ et 10¹⁸cm⁻³. Les plans de masse 11 et 21 peuvent présenter des concentrations de dopants comprises entre 10¹⁸cm⁻³ et 10¹⁹cm⁻³. Les caissons 12 et 22 peuvent s'étendre jusqu'à une profondeur inférieure à 1µm et, de préférence, inférieure ou égale à 700nm.

Des contacts métalliques peuvent être déposés après siliciuration directement sur chacun des implants 14, 17, 24, 27, afin de permettre une connexion électrique de chacun d'eux. Avantageusement, les implants 14, 17, 24, 27 présentent chacun une concentration de dopants au moins cinquante fois, ou cent fois supérieure à la concentration de dopants des caissons 12 et 22. Par exemple, les implants 14, 17, 24, 27 présentent des concentrations de dopants avantageusement supérieures ou égales à 5*10¹⁸cm⁻³ et, de préférence, comprises entre 10¹⁹cm⁻³ et 10²¹cm⁻³. Ces concentrations de dopants sont par exemple sensiblement égales aux concentrations de dopants de la source ou du drain des transistors 1 et 2.

Les implants 14, 24, 17 et 27 sont ici ménagés latéralement par rapport aux transistors 1 et 2. L'implant 14 est polarisé à un premier niveau de tension E1, l'implant 24 est polarisé à un deuxième niveau de tension E2, l'implant 17 est polarisé à un troisième niveau de tension E3 et l'implant 27 est polarisé à un quatrième niveau de tension E4.

Un dispositif de protection contre les décharges électrostatiques est inclus dans le circuit intégré 9, à l'aplomb des transistors 1 et 2. La protection contre les décharges électrostatiques vise à assurer une protection contre les décharges entre les niveaux de tension E1 et E2. Ce mode de réalisation présente une sensibilité réduite à un déclenchement accidentel (désigné par le terme latchup en langue anglaise).

La figure 3 est un schéma électrique du dispositif de protection, du type SCR (pour semiconductor controlled rectifier en langue anglaise). Des transistors bipolaires B1 et B2 sont formés.

Le transistor bipolaire B1 est un transistor pnp et le transistor B2 est un transistor npn.
Pour le transistor B1 :
- l'émetteur est formé par l'implant 14, et est au potentiel E1 ;
- la base est formée par le caisson 12, et est au potentiel E3 ;
- le collecteur est formé par le caisson 22, et est au potentiel E4.
Pour le transistor B2 :
- l'émetteur est formé par l'implant 24, et est au potentiel E2 ;
- la base est formée par le caisson 22, et est au potentiel E4 ;
- le collecteur est formé par le caisson 12, et est au potentiel E3.

Un thyristor ayant potentiellement une double commande est ainsi formé, entre les potentiels E1 et E2, les signaux E3 et E4 pouvant être appliqués sur les deux commandes de ce thyristor.

La figure 4 est un schéma électrique d'un exemple de mise en oeuvre du premier mode de réalisation. Le transistor pMOS 1 est ici un circuit devant être protégé par les transistors B1 et B2. La source du transistor 1 et son plan de masse 11 sont connectés à un potentiel d'alimentation Vdd du circuit intégré 9. Le drain du transistor 1 est connecté à un potentiel d'un signal Sgn.

Les transistors B1 et B2 assurent ici une protection locale du transistor pMOS 1 contre des décharges électrostatiques entre le potentiel d'alimentation Vdd et le signal Sgn. Vdd est ainsi appliqué comme potentiel E1, Sgn est appliqué comme potentiel E2. Une résistance R1 est ménagée entre le collecteur de B1/la base de B2 et le potentiel Sgn. Une résistance R2 est ménagée entre la base de B1/le collecteur de B2 et le potentiel Vdd.

Le transistor nMOS 2 est ici un circuit de commande du thyristor formé par les transistors B1 et B2. Le transistor 2 a sa source connectée au potentiel Sgn, son drain connecté au collecteur de B2, et son plan de masse 21 connecté au potentiel Sgn. Une résistance R3 est formée entre la grille du transistor 2 et le potentiel Sgn.

Lors d'une décharge électrostatique entre les potentiels Vdd et Sgn, le thyristor formé des transistors B1 et B2 est rendu passant par l'intermédiaire du transistor 2. Une décharge électrostatique entre les potentiels Vdd et Sgn est ici court-circuitée par le thyristor formé, ce qui protège le transistor 1.

Le circuit intégré 9 peut en outre avantageusement inclure un circuit de déclenchement additionnel 3. Le circuit de déclenchement additionnel 3 illustré inclut une capacité et une diode zener connectées en parallèle, entre la grille du transistor 2 et le potentiel Vdd.

Les valeurs des résistances R1 et R2 peuvent être des résistance caisson, définies de façon appropriée, en adaptant par exemple la profondeur des tranchées d'isolation 62. Le niveau des tensions de maintien des signaux de commande du thyristor formé peut être défini en jouant sur la distance séparant les implants 17 et 24. La valeur de résistance R3 pourra être définie par un élément additionnel.

La figure 5 est une vue en coupe transversale d'un deuxième mode de réalisation d'une cellule pour un circuit intégré selon un deuxième mode de réalisation. Des composants électroniques 1 et 2 sont réalisés dans une couche d'un matériau semi-conducteur, dite couche active, formée sur une couche isolante 92, cette couche isolante 92 étant formée à l'aplomb d'un substrat semi-conducteur 91 à dopage de type p. Comme pour le premier mode de réalisation, les composants électroniques 1 et 2 sont ici des transistors pMOS et nMOS respectivement, par exemple de type FDSOI.

Des plans de masse 11 et 21 semi-conducteurs sont formés respectivement à l'aplomb des transistors 1 et 2, sous la couche isolante enterrée 92. Le dopage du plan de masse 11 est de type p, celui du plan de masse 21 est de type n.

Les plans de masse 11 et 21 sont polarisés respectivement par des implants 14 et 24 semi-conducteurs. Les implants 14 et 24 présentent des dopages respectifs de type p et n (et de préférence des dopages P+, N+ respectivement). Les implants 14 et 24 sont coplanaires aux plans de masse 11 et 21.

Des caissons 12 et 22 semi-conducteurs sont formés respectivement, à l'aplomb des plans de masse 11 et 21. Les dopages des caissons 12 et 22 sont respectivement de type n et de type p.

Les caissons 12 et 22 sont polarisés respectivement par des implants 17 et 27 semi-conducteurs. Les implants 17 et 27 présentent des dopages respectifs de type n et p (et de préférence des dopages N+, P+ respectivement). Les implants 14, 24, 17 et 27 sont ici ménagés latéralement par rapport aux transistors 1 et 2. Les implants 14 et 17 sont ici ménagés de part et d'autre du transistor 1. Les implants 24 et 27 sont ici ménagés de part et d'autre du transistor 2.

Un caisson profondément enterré de type n peut être ménagé pour former une séparation entre les caissons 12, 22 et le substrat 91 à dopage de type p.

Des tranchées d'isolation profondes 61 et 63 sont ménagées à la périphérie de chacun des transistors 1 et 2. Les tranchées d'isolation 61 et 63 s'étendent en profondeur au travers de la couche isolante 92, jusque dans les caissons respectifs 12 et 22 pour les transistors 1 et 2.

Les transistors 1 et 2 comportent en outre des tranchées d'isolation profondes 62. Les tranchées d'isolation 62 s'étendent en profondeur au travers de la couche isolante 92, jusque dans les caissons respectifs 12 et 22 pour les transistors 1 et 2, sans atteindre le substrat 91. Les caissons 12 et 22 s'étendent latéralement à l'aplomb des implants 14,17 et 24, 27 respectivement, et sous les tranchées d'isolation 62. Les tranchées d'isolation 62 assurent une isolation entre les implants 14,17 et 24, 27 respectivement. Les tranchées d'isolation profondes 61 à 63 présentent ici avantageusement une profondeur identique.

Des tranchées d'isolation 13 et 23 sont ménagées à l'aplomb du contact entre les plans de masse 11, 21 et les implants 14, 24 respectivement. Les tranchées d'isolation 13 et 23 sont moins profondes que les tranchées d'isolation 61 à 63.

Les tranchées d'isolation 13 et 23 ne s'étendent pas jusqu'à leurs caissons 12 et 22 respectifs. Les tranchées d'isolation 13 et 23 traversent ici la couche isolante 92 et s'étendent donc jusque dans leurs plans de masse 11 et 21 respectifs. Les tranchées d'isolation 13 et 23 permettent d'améliorer l'isolation entre les transistors 1 et 2 et leurs implants 14 et 24 tout en rendant possible la polarisation des régions 11 et 21.

L'implant 14 est polarisé à un premier niveau de tension E1, l'implant 24 est polarisé à un deuxième niveau de tension E2, l'implant 17 est polarisé à un troisième niveau de tension E3 et l'implant 27 est polarisé à un quatrième niveau de tension E4. Comme dans le premier mode de réalisation, un dispositif de protection contre les décharges électrostatiques est inclus dans le circuit intégré 9, à l'aplomb des transistors 1 et 2. La protection contre les décharges électrostatiques vise à assurer une protection contre les décharges entre les niveaux de tension E1 et E2. Du fait de la distance plus réduite entre les implants 14 et 24, ce mode de réalisation présente une sensibilité accrue aux décharges électrostatiques.

La figure 6 est un schéma électrique d'un exemple de mise en oeuvre du deuxième mode de réalisation. Le transistor nMOS 2 est ici un circuit devant être protégé par les transistors B1 et B2. Le drain du transistor 2 est connecté à un potentiel d'un signal Sgn du circuit intégré 9. La source du transistor 2 et son plan de masse 21 sont connectés à un potentiel de masse Gnd.

Les transistors B1 et B2 assurent ici une protection locale du transistor nMOS 2 contre des décharges électrostatiques entre le signal Sgn et le potentiel Gnd. Sgn est ainsi appliqué comme potentiel E1, Gnd est appliqué comme potentiel E2. Une résistance R1 est ménagée entre le collecteur de B1/la base de B2 et le potentiel Gnd. Une résistance R2 est ménagée entre la base de B1/le collecteur de B2 et le potentiel Sgn.

Le transistor pMOS 1 est ici un circuit de commande du thyristor formé par les transistors B1 et B2. Le transistor 1 a sa source connectée au potentiel Sgn, son drain connecté au collecteur de B1, et son plan de masse 11 connecté au potentiel Sgn. Une résistance R4 est formée entre la grille du transistor 1 et le potentiel Sgn.

Lors d'une décharge électrostatique entre les potentiels Sgn et Gnd, le thyristor formé des transistors B1 et B2 est rendu passant par l'intermédiaire du transistor 1. Une décharge électrostatique entre les potentiels Sgn et Gnd est ici court-circuitée par le thyristor formé, ce qui protège le transistor 2.

Le circuit intégré 9 peut en outre avantageusement inclure un circuit de déclenchement additionnel 4. Le circuit de déclenchement additionnel 4 illustré inclut une capacité et une diode zener connectées en parallèle, entre la grille du transistor 1 et le potentiel Gnd.

La figure 7 est un schéma électrique d'une autre application d'un circuit intégré selon l'invention. Dans ce mode de réalisation, les transistors 1 et 2 sont destinés à commander les transistors B1 et B2 formés, pour assurer une protection centralisée pour d'autres composants, entre les potentiels E1 et E2. Le transistor 2 reprend la configuration détaillée en référence à la figure 3. Le transistor 1 reprend la configuration détaillée en référence à la figure 6. Dans ce mode de réalisation, le transistor 1 ou le transistor 2 peuvent appliquer une commande rendant le thyristor formé passant. Le schéma électrique illustre des circuits de déclenchement additionnels 3 et 4, tels que détaillés en référence aux figures 3 et 6.

La figure 8 est une vue en coupe transversale d'une variante de l'invention, ici appliquée au premier mode de réalisation. En variante, une reprise d'épitaxie peut être effectuée sur les implants 14, 24, 17 et 27, pour éviter la différence d'altitude avec les couches actives 15 et 25. Dans cet exemple, les implants 14 et 24 s'étendent plus profondément que la couche 92, et plus profondément que les tranchées d'isolation 13 et 23.

Bien que les thyristors formés et illustrés présentent structurellement deux électrodes de commande, l'invention peut également être mise en oeuvre en formant une unique électrode de commande.

En variante, un nMOS peut être réalisé sur un plan de masse dopé p, et/ou un pMOS peut être réalisé sur un plan de masse dopé n.

## Revendications

1. Circuit intégré (9), comprenant :
- des premier et deuxième composants électroniques (1, 2) ;
- une couche isolante enterrée (92) de type UTBOX, disposée sous et à l'aplomb des composants électroniques ;
- des premier et deuxième plans de masse (11, 21) ménagés à l'aplomb respectivement des premier et deuxième composants électroniques sous la couche isolante enterrée (92) ;
- des premier et deuxième caissons (12, 22) en contact, respectivement ménagés à l'aplomb et en contact avec les premier et deuxième plans de masse, le premier caisson présentant un premier type de dopage, le deuxième caisson présentant un second type de dopage opposé au premier ;
- des première et deuxième électrodes (14, 24) de polarisation en contact respectivement avec les premier et deuxième caissons et avec les premier et deuxième plans de masse, la première électrode étant adaptée à être connectée à une première tension de polarisation (E1) et présentant le deuxième type de dopage, la deuxième électrode étant adaptée à être connectée à une deuxième tension de polarisation (E2) différente de la première tension et présentant le premier type de dopage ;
- une troisième électrode (17) en contact avec le premier caisson et présentant le même dopage que ce caisson ;
- une première tranchée d'isolation (62) séparant les première et troisième électrodes et s'étendant au travers de la couche isolante enterrée (92) jusque dans le premier caisson ;
- une deuxième tranchée d'isolation (13) isolant la première électrode du premier composant, et ne s'étendant pas jusqu'à l'interface entre le premier plan de masse et le premier caisson.

2. Circuit intégré selon la revendication 1, comprenant un dispositif de détection d'une décharge électrostatique, configuré pour détecter une décharge électrostatique et pour appliquer un signal de commande sur la troisième électrode (17) lors de la détection d'une décharge.

3. Circuit intégré selon la revendication 1 ou 2, dans lequel les premier et deuxième composants électroniques (1,2) sont respectivement des premier et deuxième transistors FDSOI.

4. Circuit intégré selon les revendications 2 et 3, dans lequel ledit premier transistor FDSOI (1) est inclus dans le circuit de commande et est adapté à générer ledit signal de commande.

5. Circuit intégré (9) selon la revendication 3, dans lequel un desdits transistors FDSOI a son drain couplé à l'une parmi la première ou la deuxième électrode et sa source couplée à l'autre parmi la première ou la deuxième électrode.

6. Circuit intégré selon l'une quelconque des revendications 3 à 5, dans lequel un desdits transistors est un transistor nMOS et l'autre desdits transistors est un transistor pMOS.

7. Circuit intégré selon l'une quelconque des revendications précédentes, dans lequel lesdites première et troisième électrodes (14,17) incluent chacune un implant semi-conducteur présentant une concentration de dopants au moins 50 fois supérieure à la concentration de dopants dans le premier caisson (12).

8. Circuit intégré selon l'une quelconque des revendications précédentes, dans lequel la deuxième tranchée d'isolation (13) s'étend au travers de la couche isolante enterrée (92) jusque dans le premier plan de masse (11) et jusqu'à une profondeur strictement inférieure à l'interface entre le premier plan de masse et le premier caisson (12).

9. Circuit intégré selon l'une quelconque des revendications précédentes, comprenant en outre une troisième tranchée d'isolation (61) isolant les premier et deuxième composants et s'étendant au travers de la couche isolante enterrée (92) jusque dans le premier caisson (12).

10. Circuit intégré selon l'une quelconque des revendications précédentes, dans lequel le premier transistor (1) est disposé entre la troisième électrode (17) et la première électrode (14).

11. Circuit intégré selon les revendications 9 et 10, dans lequel la première électrode (14) est disposée entre la troisième tranchée d'isolation (61) et le premier transistor (1).

12. Circuit intégré selon l'une quelconque des revendications 1 à 9, dans lequel les première et troisième électrodes (14,17) sont en contact avec la première tranchée d'isolation (62) de part et d'autre de celle-ci.

13. Circuit intégré selon les revendications 9 et 12, dans lequel le premier transistor (1) est disposé entre la première électrode (14) et la troisième tranchée d'isolation (61).

14. Circuit intégré selon l'une quelconque des revendications précédentes, dans lequel la partie supérieure de la troisième électrode (17) est affleurante à la partie supérieure de la première tranchée d'isolation (62).
